# EUROPEAN PATENT APPLICATION

(11) **EP 4 546 115 A1**
(43) Date of publication of application: **30.04.2025**
(21) Application number: 23825787.7
(22) Date of filing: 16.02.2023
(51) Int. Cl.: G06F 8/20

(54) **SOFTWARE MODEL ARCHITECTURE, BATTERY MANAGEMENT SYSTEM CONTROLLER AND VEHICLE**

(30) Priority: 24.06.2022 CN 202210734035
(71) Applicant: BYD Company Limited, Shenzhen, Guangdong 518118 (CN)
(72) Inventor: YUE, Xiang, Shenzhen, Guangdong 518118 (CN); SHEN, Xiaofeng, Shenzhen, Guangdong 518118 (CN); HUA, Chongru, Shenzhen, Guangdong 518118 (CN)
(74) Representative: Wu, Ting
(86) International application number: PCT/CN2023/076339
(87) International publication number: WO 2023/246128

(57) **Abstract**

Provided in the present disclosure are a software model architecture, a battery management system controller and a vehicle. The model architecture comprises a first function calling unit, a logic unit and a second function calling unit, which are connected in sequence, wherein the first function calling unit is used for reading a function value of an external function and outputting the function value to the logic unit; the logic unit is used for executing preset computation logic according to the function value and outputting a first computation result to the second function calling unit; and the second function calling unit is used for writing the first computation result into the external function. When the model architecture is in an offline debugging state, the logic unit is in a separated state in which the logic unit is respectively independent of the first function calling unit and the second function calling unit.

## Description

### CROSS-REFERENCE TO RELATED APPLICATIONS

The present disclosure claims priority to and benefits of Chinese Patent Application No. 202210734035.2, filed on June 24, 2022, and entitled "SOFTWARE MODEL ARCHITECTURE, BATTERY MANAGEMENT SYSTEM CONTROLLER AND VEHICLE". The entire content of the above-referenced application is incorporated herein by reference.

### FIELD

The present disclosure relates to the field of software model development technologies, and more specifically, to a software model architecture, a battery management system controller, and a vehicle.

### BACKGROUND

An embedded software model architecture is used in many scenarios because the embedded software model architecture has characteristics such as strong model visibility, convenient maintenance, automatic code generation, and being suitable for writing complex logic.

With renewal of products, the embedded software model architecture needs to be debugged and updated. During offline debugging of an existing model, because a processing unit of the model has a capability of calling an external function, the entire model fails in simulation because the corresponding function cannot be located. As a result, some function modules need to be manually deleted. Each time the model needs to be tested offline when the model is modified, the model needs to be changed, resulting in heavy workload, low efficiency, and a risk of an abnormal model capability caused by a change error.

It can be learned that improving the existing model is a problem that needs to be resolved urgently.

### SUMMARY

An object of the present disclosure is to provide a new technical solution of a software model architecture, a battery management system controller, and a vehicle.

According to a first aspect of the present disclosure, a software model architecture is provided. The model architecture includes: a first function calling unit, a logic unit, and a second function calling unit that are connected in sequence.

The first function calling unit is configured to read a function value of an external function, and output the function value to the logic unit.

The logic unit is configured to perform preset calculation logic based on the function value, and output a first calculation result to the second function calling unit.

The second function calling unit is configured to write the first calculation result into the external function.

When the model architecture is in an offline debugging state, the logic unit is in a separated state in which the logic unit is respectively independent of the first function calling unit and the second function calling unit.

Optionally, when the logic unit is in the offline debugging state, the logic unit is connected to an output observer, and the logic unit is configured to:
receive input operating-condition information; and
debug the model architecture based on the input operating-condition information, and output a debugging result to the output observer, and the output observer is configured to display the debugging result.

Optionally, the model architecture further includes: an input calibration unit and an output calibration unit.

The input calibration unit is configured to calibrate a received to-be-calibrated signal when the model architecture is in an online debugging state, to obtain input calibration data. The to-be-calibrated signal includes an input signal received by the input calibration unit and the function value of the external function read by the first function calling unit.

The logic unit is configured to perform preset calculation logic based on the input calibration data, and output a second calculation result to the output calibration unit.

The output calibration unit is configured to calibrate the second calculation result to obtain output calibration data, and output the output calibration data through an output end of the model architecture.

Optionally, a first input end of the input calibration unit is an input end of the model architecture, and a second input end of the input calibration unit is connected to an output end of the first function calling unit.

An output end of the input calibration unit is connected to a first end of the logic unit, and a second end of the logic unit is connected to an input end of the output calibration unit.

A first output end of the output calibration unit is the output end of the model architecture, and a second output end of the output calibration unit is connected to an input end of the second function calling unit.

Optionally, the output calibration unit is further configured to transmit the output calibration data to the second function calling unit, to cause the second function calling unit to write the output calibration data into the external function.

Optionally, the input calibration unit is configured with a calibration switch and a calibration value that is in a one-to-one correspondence with the to-be-calibrated signal, and that the input calibration unit calibrates a received to-be-calibrated signal when the model architecture is in an online debugging state includes:
the to-be-calibrated signal is calibrated based on the calibration switch and the calibration value. The calibration switch includes a turned-on state and a turned-off state, and the calibration value includes the to-be-calibrated signal or a preset value corresponding to the to-be-calibrated signal.

Optionally, that the calibration unit calibrates the to-be-calibrated signal based on the calibration switch and the calibration value includes:
a calibration instruction inputted by a user is received, and the calibration instruction is used for controlling the turned-on state or the turned-off state of the calibration switch.

When the calibration instruction is that the calibration switch is in the turned-on state, the calibration value corresponding to the to-be-calibrated signal is outputted.

When the calibration instruction is to turn off the calibration switch, the to-be-calibrated signal is outputted.

Optionally, the model architecture further includes a model auxiliary unit, and the model auxiliary unit is configured to store model information.

The model information includes a model version number, a model item number, and a model scheduling period of the model architecture.

Optionally, the model auxiliary unit is configured to:
receive, when the software model architecture is in the online debugging state, a query instruction inputted by the user; and
output the model information based on the query instruction.

According to a second aspect of the present disclosure, a battery management system controller is further provided. The battery management system controller includes a control chip and a software model architecture arranged on the control chip. The software model architecture is the software model architecture according to any one of the first aspect.

According to a second aspect of the present disclosure, a vehicle is further provided. The vehicle includes the battery management system controller according to the second aspect.

One beneficial effect of the present disclosure is that, in the software model architecture of this embodiment, a function value of an external function is read by a first function calling unit, and the function value is outputted to a logic unit, to cause the logic unit to perform preset calculation logic according to the function value, and output a first calculation result. In addition, the first calculation result is written into the external function by a second function calling unit. In this way, a capability of the model architecture is implemented, and a read/write capability of the logic unit can be separated. When the model architecture is in an offline debugging state, the logic unit may be separated from the first function calling unit and the second function calling unit respectively. In this way, there is no external function calling capability inside the logic unit, to facilitate offline debugging of the logic unit, which can greatly improve debugging efficiency of a model.

Other features and advantages of the present disclosure will become apparent from the following detailed description of exemplary embodiments of the present disclosure with reference to the accompanying drawings.

### BRIEF DESCRIPTION OF THE DRAWINGS

Accompanying drawings are incorporated into and constitute a part of this specification, show embodiments that conform to the present disclosure, and are used together with this specification to describe the principle of the present disclosure.
FIG. 1 shows a software model architecture according to an embodiment;
FIG. 2 is a schematic diagram of a model architecture in an offline debugging state according to an embodiment;
FIG. 3 shows another model architecture according to an embodiment;
FIG. 4 is a flowchart of calibration of an input calibration unit according to an embodiment;
FIG. 5 is a schematic block diagram of a structure of a battery management system controller according to an embodiment; and
FIG. 6 is a block diagram of a structure of a vehicle according to an embodiment.

### DETAILED DESCRIPTION

Various exemplary embodiments of the present disclosure are now described in detail with reference to the accompanying drawings. It should be noted that, unless otherwise specified, the relative deployment, the numerical expression, and values of the components and steps described in the embodiments do not limit the scope of the present disclosure.

The following descriptions of at least one exemplary embodiment are merely illustrative, and in no way constitute any limitation on the present disclosure and application or use of the present disclosure.

Technologies, methods, and devices known to those of ordinary skill in related arts may not be discussed in detail, but where appropriate, the techniques, the methods, and the devices should be considered as a part of the specification.

In all examples shown and discussed herein, any specific value should be construed as merely exemplary and not as limitations. Therefore, other examples of exemplary embodiments may have different values.

It should be noted that, similar reference signs or letters in the accompanying drawings indicate similar items. Therefore, once an item is defined in one accompanying drawing, the item does not need to be further discussed in the subsequent accompanying drawings.

An application scenario of the embodiments of the present disclosure is a scenario of development of a software model.

In development of an embedded software model in the automotive field, model designing is increasingly used to meet increasing capability requirements. In comparison with handwritten code, the model has strong model visibility, convenient maintenance, automatic code generation, and is suitable for writing complex logic.

In a model architecture, different capabilities are divided by establishing different regions and blocks, and then logical models are constructed and code is filled in the different regions, to finally implement effective operating of an entire model capability. Subsequent maintenance, porting, and expansion of the model can be completed according to a clear architectural indication. A good model architecture can make maintenance work more effective.

An existing model architecture is generally divided into several units. The units or the unit and the outside are connected by using a signal. Capabilities of the units are independent. Each unit is filled with a model or code, and the unit executes different calculation logic respectively. With renewal of products, an embedded software model architecture needs to be debugged and updated. During offline debugging of an existing model, debugging software is used to perform simulation and debugging on the model on a computer desktop. Because a capability of calling an external function of the existing model is integrated into each unit, during offline debugging, the entire model fails in simulation because the corresponding function cannot be located. As a result, some modules need to be manually deleted. Each time the model needs to be tested offline when the model is modified, the model needs to be changed, resulting in heavy workload, low efficiency, and a risk of an abnormal model capability caused by a change error.

In addition, during online debugging of the existing model, software may be flushed to a single-chip microcomputer. During online running, debugging software is used to debug a software capability. However, because the existing model does not calibrate input and output units in batches, output signals inputted by the model cannot be modified on a large scale. To achieve an objective of online debugging, a CAN message needs to be additionally debugged outside the software, and a small quantity of input and output signals of the model are simulated and observed by using a CAN message signal. In this solution, due to a limitation of CAN communication load, not all input and output signals can be simulated, resulting in insufficient coverage of a simulation operating condition and a slow troubleshooting speed.

For the technical problems existing in the foregoing embodiments, a software model architecture is proposed. A capability of calling an external function is separated from a capability unit, so that function calling is separated from a capability of the capability unit, to achieve quick implementation and switching of offline testing of the model. In addition, a calibration unit is added, to calibrate the signals in batches during online debugging, so that online debugging can be quickly implemented.

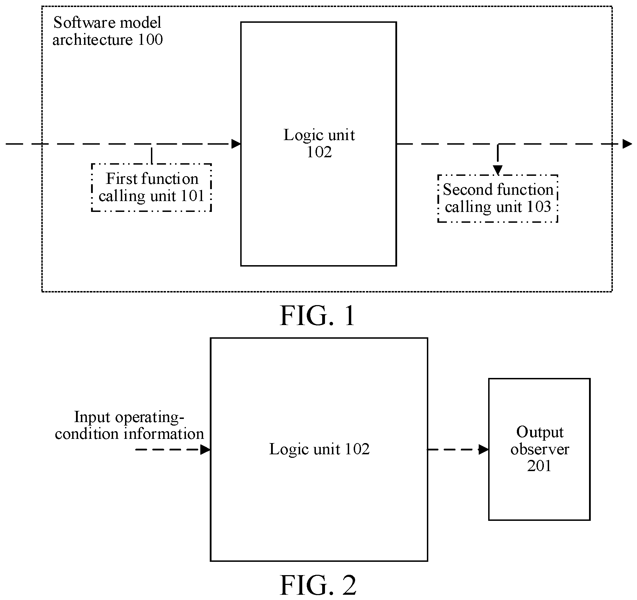

FIG. 1 shows a software model architecture according to an embodiment. Referring to FIG. 1, a model architecture 100 includes: a first function calling unit 101, a logic unit 102, and a second function calling unit 103 that are connected in sequence. An output end of the first function calling unit is connected to an input end of the logic unit, and an output end of the logic unit is connected to an input end of the second function calling unit.

In this embodiment, the first function calling unit is configured to read a function value of an external function, and output the function value to the logic unit. The external function is a function outside the model architecture, to cause a software model to perform logic calculation on the software model.

The first function calling unit only has a capability of reading data. When the software model is connected to an external device, the function value of the external function may be read, so that a capability of the logic unit when the software model normally runs is not affected. When the model needs to be debugged, the first function calling unit and the logic unit may be disconnected, to reduce a case in which a capability of calling a function is manually deleted, thereby improving efficiency of offline debugging of the model.

In this embodiment, the logic unit is configured to perform preset calculation logic based on the function value, and output a first calculation result to the second function calling unit.

The logic unit may include a number of capability units, and each capability unit executes different preset logic to implement different preset capabilities. Specific preset logic may be implemented by manually writing a program.

In this embodiment, during normal running of the model, the input end of the logic unit may further receive an input signal, to perform normal calculation logic based on the input signal, so as to obtain a calculation result, and output the calculation result to the outside of the model through the output end of the logic unit. In addition, the logic unit may further receive the function value outputted by the first function calling unit, and may alternatively output the calculation result to the second function calling unit.

In this embodiment, the second function calling unit is configured to write the first calculation result into the external function. To be specific, the second function calling unit may receive the first calculation result outputted by the logic unit in the model. The first calculation result may be a signal value or a function value. The second function calling unit may use the first calculation result as a parameter inputted into the external function, to cause the first calculation result to participate in calling and executing the external function.

It can be learned that, the first function calling unit may call the function value of the external function. The logic unit performs calculation based on the function value, and outputs a second calculation result. The second function calling unit may use the second calculation result as a parameter inputted into the external function, thereby implementing normal running of the software model architecture of this embodiment.

In addition, when the model architecture is in an offline debugging state, the logic unit is in a separated state in which the logic unit is respectively independent of the first function calling unit and the second function calling unit. In this way, the logic unit may be separated and put into an offline debugging environment, to facilitate offline debugging of the logic unit. In this case, because there is no function calling unit in the logic unit, the function calling unit does not need to be manually searched for and deleted, so that a possibility that a model capability is abnormal due to a function calling error can be reduced.

Referring to FIG. 2, FIG. 2 is a schematic diagram of a model architecture in an offline debugging state according to an embodiment. When the logic unit is in the offline debugging state, the logic unit 102 is connected to an output observer 201. The logic unit is configured to: receive input operating-condition information; and debug the model architecture based on the input operating-condition information, and output a debugging result to the output observer, the output observer being configured to display the debugging result.

For example, the input operating-condition information may include a traveling speed, a battery voltage, and the like of the vehicle. In the offline debugging state, the input end of the logic unit may be configured to receive the input operating-condition information. The output end of the logic unit is connected to the output observer. The logic unit performs preset calculation logic based on the input operating-condition information such as the traveling speed and the battery voltage of the vehicle, and outputs, to the output observer, the debugging result indicating whether the model is suitable. The output observer is configured to display the debugging result for debug personnel to observe. In addition, the output observer may further store a preset debugging result, and compare the debugging result outputted by the logic unit with the preset debugging result, to more intuitively observe whether the model is as expected.

In the model architecture of this embodiment, when detecting that logic of the logic unit changes, testing personnel only needs to update the logic unit to perform retesting. In this way, the logic unit can be quickly switched, and debugging efficiency can be improved.

In the software model architecture of this embodiment, the first function calling unit reads the function value of the external function, and outputs the function value to the logic unit, to cause the logic unit to perform preset calculation logic based on the function value, and output the first calculation result. In addition, the first calculation result is written into the external function by using the second function calling unit. In this way, during implementation of a capability of the model architecture, a read/write capability of the logic unit can be separated. When the model architecture is in the offline debugging state, the logic unit may be separated from the first function calling unit and the second function calling unit respectively. In this way, the capability of calling the external function does not exist in the logic unit, to facilitate offline debugging of the logic unit, so that debugging efficiency of the model can be greatly improved.

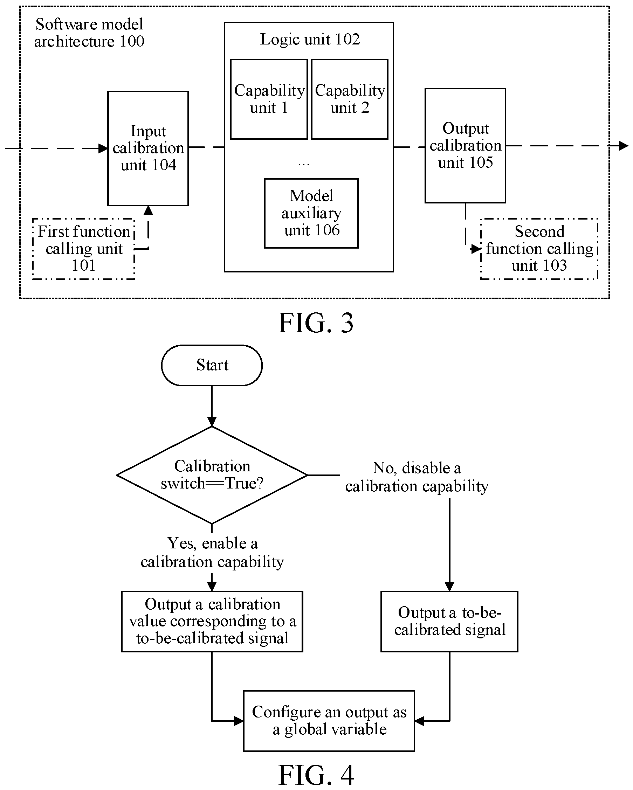

FIG. 3 shows another model architecture according to an embodiment. Referring to FIG. 3, the model architecture of this embodiment not only includes the first function calling unit 101, the logic unit 102, and the second function calling unit 103 shown in FIG. 1, but also includes: an input calibration unit 104 and an output calibration unit 105.

A first input end of the input calibration unit is an input end of the model architecture, and a second input end of the input calibration unit is connected to the output end of the first function calling unit. An output end of the input calibration unit is connected to a first end of the logic unit, and a second end of the logic unit is connected to an input end of the output calibration unit. A first output end of the output calibration unit is the output end of the model architecture, and a second output end of the output calibration unit is connected to the input end of the second function calling unit.

In this embodiment, when the model architecture is in an online debugging state, the input calibration unit is configured to calibrate a received to-be-calibrated signal to obtain input calibration data, and output the input calibration data to the logic unit. The logic unit is configured to perform preset calculation logic based on the input calibration data, and output a second calculation result to the output calibration unit. The output calibration unit is configured to calibrate the second calculation result to obtain output calibration data, and output the output calibration data through the output end of the model architecture.

It should be noted that when the model architecture is in a non-online debugging state, that is, a normal running state, the input calibration unit may be in a sleep state. In other words, when the model is in the non-online debugging state, the input calibration unit does not calibrate the input signal, to cause the logic unit to perform preset running logic.

When the model architecture is in the online debugging state, a calibration capability of the model architecture may be triggered.

In addition, when the input calibration unit may be in the sleep state, the output calibration unit may also be in the sleep state. In this case, a running principle of the model architecture is shown in FIG. 1, and offline debugging can also be implemented. To be specific, the model architecture shown in FIG. 3 can implement both offline debugging and online debugging, so that applicability of the model can be improved.

In this embodiment, the to-be-calibrated signal received by the input calibration unit includes the input signal received by the calibration unit and the function value of the external function read by the first function calling unit. The input signal received by the calibration unit may be a signal required for normal running of the model, for example, running data of a vehicle. The function value of the external function read by the first function calling unit may be a return value that is of the external function and that is set by working personnel to implement a function of the vehicle.

The input calibration unit may fuse and calibrate all signals that are to be inputted into the logic unit and then output the signals to the logic unit. The input signal is calibrated, so that online simulation and calibration of the signal inputted into the model can be implemented to simulate different test operating conditions, and types and a quantity of the test operating conditions are increased.

In this embodiment, the logic unit may include a number of capability units inside, such as a capability unit 1 and a capability unit 2 shown in FIG. 3.

Correspondingly, the output calibration unit in this embodiment may calibrate the second calculation result outputted by the logic unit to obtain the output calibration data. In addition, the output calibration data is outputted through the output end of the model architecture, and the output calibration data is sent to the second function calling unit, to cause the second function calling unit to write the output calibration data into the external function. The output signal is calibrated, so that online simulation and calibration of the signal outputted by the model can be implemented to simulate different test operating conditions, and types and quantity of the test operating conditions are increased.

In this embodiment, the input calibration unit is configured with a calibration switch and a calibration value that is in a one-to-one correspondence with the to-be-calibrated signal. That the input calibration unit calibrates the received to-be-calibrated signal when the model architecture is in the online debugging state includes: the input calibration unit calibrates the to-be-calibrated signal based on the calibration switch and the calibration value. The calibration switch includes a turned-on state and a turned-off state, and the calibration value includes the to-be-calibrated signal or a preset value corresponding to the to-be-calibrated signal.

It should be noted that when the model in this embodiment is in the online debugging state or the offline debugging state, a debugging signal may be inputted to the model through an explicit control protocol (Explicit Control Protocol, XCP) tool.

In this embodiment, that the input calibration unit calibrates the to-be-calibrated signal according to the calibration switch and the calibration value includes: a calibration instruction inputted by a user is received, and the calibration instruction is used for controlling the turned-on state or the turned-off state of the calibration switch. When the calibration instruction is to turn off the calibration switch, the calibration value corresponding to the to-be-calibrated signal is outputted. When the calibration instruction is that the calibration switch is in the turned-off state, the to-be-calibrated signal is outputted.

For example, the user may input the calibration instruction through the XCP tool. The calibration instruction may control enabling or disabling of the calibration switch. FIG. 4 is a flowchart of calibration of an input calibration unit according to an embodiment. Referring to FIG. 4, in the turned-on state of the calibration switch, a value corresponding to the calibration switch may be True. When the calibration switch is True, the input calibration unit enables the calibration capability, and outputs the calibration value corresponding to the to-be-calibrated signal. When the value corresponding to the calibration switch is not True, the input calibration unit disables the calibration capability, and the outputted data is the to-be-calibrated signal, that is, the input signal of the input calibration unit is kept unchanged. It should be noted that the data outputted by the input calibration unit in this embodiment is configured as a global variable, to facilitate calling of the data in a debugging process. That is, the calibration value and the calibration switch are defined in software as readable and writable global variables.

Similarly, the output calibration unit is also configured with a calibration switch and a calibration value that is in a one-to-one correspondence with the second calculation result outputted by the logic unit. The output calibration unit may calibrate the second calculation result according to the calibration switch and the calibration value. Then, calibrated data is outputted through the output end of the model, and the calibrated data is written into the second function calling unit.

This embodiment provides a model architecture, including a first function calling unit, a logic unit, a second function calling unit, an input calibration unit, and an output calibration unit. The input calibration unit calibrates an input signal of a model and a function value called by the first function calling unit, output data of the logic unit is calibrated through the output calibration unit and then outputted through an output end of the model, and calibrated data is written into the second function calling unit. In this way, the input and output signals of the model can be calibrated. Therefore, online simulation and calibration of the input and output signals of the model may be implemented to simulate different test operating conditions and increase types and quantities of the test operating conditions.

Referring to FIG. 3, the model architecture of this embodiment further includes a model auxiliary unit 106. The model auxiliary unit 106 is configured to store model information, and the model information includes a model version number, a model item number, and a model scheduling period of the model architecture. To facilitate the user to call the model information, online traceability and verification of a running period of a model version are supported, and efficiency of problem troubleshooting is improved.

The model auxiliary unit 106 may be arranged in the logic unit. The model auxiliary unit 106 is configured to: receive, when the software model architecture is in the online debugging state, a query instruction inputted by the user; and output the model information based on the query instruction.

For example, the user transmits the query instruction to the model auxiliary unit through the XCP tool, and the model auxiliary unit calls the stored model information in response to the query instruction, so that the user observes the model version number and the item number. This can support location of the model version and the item, thereby quickly troubleshooting the model in reverse, and improving accuracy and efficiency of problem troubleshooting.

The model scheduling period in this embodiment may be obtained by observing a model scheduling counter. Each time the model is scheduled, a value of the model scheduling counter is increased by 1. The model scheduling period is confirmed by obtaining a time interval during which the value of the model scheduling counter is increased each time, thereby verifying stability of the software model. If the time interval is more stable, the stability of the software model is better.

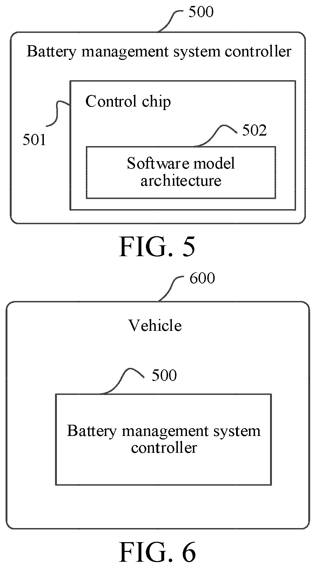

FIG. 5 is a schematic block diagram of a structure of a battery management system controller according to an embodiment.

The battery management system controller 500 includes a control chip 501 and a software model architecture 502 arranged on the control chip 501. The software model architecture 502 is the software model architecture shown in FIG. 1 or FIG. 3. Specifically, structures and capabilities of modules are described in the foregoing embodiments. To avoid repetition, details are not described herein again.

The battery management system controller provided in this embodiment may read the function value of the external function through the first function calling unit of the software model architecture, and output the function value to the logic unit, to cause the logic unit to perform preset calculation logic according to the function value, and output the first calculation result. In addition, the second function calling unit writes the first calculation result into the external function. In this way, during implementation of a capability of the model architecture, a read/write capability of the logic unit can be separated. When the model architecture is in the offline debugging state, the logic unit may be separated from the first function calling unit and the second function calling unit respectively. In this way, the capability of calling the external function does not exist in the logic unit, to facilitate offline debugging of the logic unit, so that debugging efficiency of the model can be greatly improved, and debugging efficiency of the battery management system controller is improved.

FIG. 6 is a schematic block diagram of a structure of a vehicle according to an embodiment. A vehicle 600 includes the battery management system controller 500 in the foregoing embodiment.

The battery management system controller 500 includes the control chip 501 and the software model architecture 502 arranged on the control chip. The software model architecture 502 is the software model architecture shown in FIG. 1 or FIG. 3.

Embedded software development in the vehicle field increasingly adopts a model design to meet increasing functional requirements. It can be learned that, in the vehicle 600 using the battery management system controller 500 in this embodiment, because the battery management system controller 500 includes the software model architecture 502, debugging efficiency of the vehicle can be improved.

The logic unit of the present disclosure may be a system, a method, and/or a computer program product. The computer program product may include a computer-readable storage medium, which carries computer-readable program instructions configured to cause a processor to implement aspects of the present disclosure.

The computer-readable storage medium may be a physical device that can retain and store an instruction used by an instruction-executing device. The computer-readable storage medium may be, for example, but is not limited to, an electrical storage device, a magnetic storage device, an optical storage device, an electromagnetic storage device, a semiconductor storage device, or any appropriate combination of the above. In a more specific example (a non-exhaustive list), the computer-readable storage medium includes a portable computer disk, a hard disk, a random access memory (RAM), a read-only memory (ROM), an erasable programmable read-only memory (EPROM or flash memory), a static random access memory (SRAM), a portable compact disk read-only memory (CD-ROM), a digital versatile disk (DVD), a memory stick, a floppy disk, a mechanical coding device such as a punched card or protrusion in a groove in which instructions are stored, and any appropriate combination of the above. The computer-readable storage medium as used herein is not explained as a transient signal itself, such as a radio wave or other electromagnetic waves propagated freely, an electromagnetic wave propagated through a waveguide or other transmission media (for example, a light pulse propagated through an optical fiber cable), or an electrical signal transmitted over a wire.

The computer-readable program instructions described herein can be downloaded to each computing/processing device from the computer-readable storage medium or to an external computer or external storage device through a network, for example, the Internet, a local area network, a wide area network, and/or a wireless network. The network may include a copper transmission cable, fiber transmission, wireless transmission, a router, a firewall, a switch, a gateway computer, and/or an edge server. A network adapter card or network interface in each computing/processing device receives the computer-readable program instructions from the network and forwards the computer-readable program instructions for storage in a computer-readable storage medium within each computing/processing device.

Computer program instructions used by the control unit to perform operations of the present disclosure may be assembly instructions, instruction set architecture (ISA) instructions, machine instructions, machine-related instructions, microcode, firmware instructions, status setting data, or source code or object code written in any combination of one or more programming languages. The programming languages including object-oriented programming languages such as Smalltalk and C++, and conventional procedural programming languages such as "C" language or similar programming languages. The computer-readable program instructions may be executed entirely on a computer of a user, partly on the computer of the user, as a stand-alone software package, partly on the computer of the user and partly on a remote computer, or entirely on the remote computer or a server. For the case involving a remote computer, the remote computer may be connected to a computer of a user through any type of network including a local area network (LAN) or a wide area network (WAN), or may be connected to an external computer (for example, through the Internet by using an Internet service provider). In some embodiments, an electronic circuit, such as a programmable logic circuit, a field programmable gate array (FPGA), or a programmable logic array (PLA), is customized by using status information of the computer-readable program instructions. The electronic circuit may execute the computer-readable program instructions to implement various aspects of the present disclosure.

Aspects of the present disclosure are described herein with reference to flowcharts and/or block diagrams of methods, apparatuses (systems), and computer program products according to the embodiments of the present disclosure. It may be understood that each block of the flowcharts and/or block diagrams, and combinations of blocks in the flowcharts and/or block diagrams, can be implemented by the computer-readable program instructions.

The computer-readable program instructions may be provided to a processor of a general-purpose computer, a special-purpose computer, or another programmable data processing apparatus, to produce a machine. In this way, when the instructions are executed by the processor of the computer or the another programmable data processing apparatus, an apparatus for implementing the capabilities/actions specified in one or more blocks in the flowcharts and/or block diagrams is generated. The computer-readable program instructions may alternatively be stored in the computer-readable storage medium, and the instructions cause the computer, the programmable data processing apparatus, and/or another device to operate in a specific manner. Therefore, the computer-readable storage medium storing the instructions includes an article of manufacture, including instructions for implementing aspects of the capabilities/actions specified in one or more blocks in the flowcharts and/or block diagrams.

The computer-readable program instructions may also be loaded onto a computer, another programmable data processing apparatus, or another device, to cause a series of operation steps to be performed on the computer, the another programmable data processing apparatus, or the another device to generate a computer-implemented process, so that the instructions executed on the computer, the another programmable data processing apparatus, or the another device implement the capabilities/actions specified in one or more blocks in the flowcharts and/or block diagrams.

The flowcharts and block diagrams in the accompanying drawings show the architecture, capability, and operation of possible implementations of systems, methods and computer program products according to various embodiments of the present disclosure. In this regard, each box in a flowchart or a block diagram may represent a module, a program segment, or a part of instructions. The module, the program segment, or the part of instructions includes one or more executable instructions used for implementing specified logic capabilities. In some implementations used as substitutes, capabilities marked in boxes may alternatively occur in a sequence different from that marked in an accompanying drawing. For example, two consecutive boxes may actually be performed basically in parallel, and sometimes the two boxes may be performed in a reverse sequence. This is determined by a related capability. Each block in the block diagram and/or the flowchart, and a combination of blocks in the block diagram and/or the flowchart may be implemented by using a dedicated hardware-based system that performs a specified capability or action, or may be implemented by using a combination of dedicated hardware and computer instructions. It is well known to a person skilled in the art that implementation in a hardware manner, implementation in a software manner, and implementation in a combination of software and hardware are equivalent.

The embodiments of the present disclosure are described above, and the foregoing descriptions are exemplary but not exhaustive and are not limited to the disclosed embodiments. Without departing from the scope and spirit of the described embodiments, many modifications and variations are apparent to a person of ordinary skill in the technical field. The selected terms used herein is intended to best explain the principles of the embodiments, practical applications, or improvements of technologies in the market, or to cause other persons of ordinary skill in the technical field to understand the embodiments disclosed herein. The scope of the present disclosure is limited only by the appended claims.

## Claims

1. A software model architecture, comprising: a first function calling unit, a logic unit, and a second function calling unit that are connected in sequence;
the first function calling unit being configured to read a function value of an external function, and output the function value to the logic unit;
the logic unit being configured to perform preset calculation logic based on the function value, and output a first calculation result to the second function calling unit; and
the second function calling unit being configured to write the first calculation result into the external function,
wherein when the model architecture is in an offline debugging state, the logic unit is in a separated state in which the logic unit is respectively independent of the first function calling unit and the second function calling unit.

2. The model architecture according to claim 1, wherein when the logic unit is in the offline debugging state, the logic unit is connected to an output observer, and the logic unit is configured to:
receive input operating-condition information; and
debug the model architecture based on the input operating-condition information, and output a debugging result to the output observer, the output observer being configured to display the debugging result.

3. The model architecture according to claim 1 or 2, further comprising: an input calibration unit and an output calibration unit,
the input calibration unit being configured to calibrate a received to-be-calibrated signal when the model architecture is in an online debugging state, to obtain input calibration data, wherein the to-be-calibrated signal comprises an input signal received by the input calibration unit and the function value of the external function read by the first function calling unit;
the logic unit being configured to perform preset calculation logic based on the input calibration data, and output a second calculation result to the output calibration unit; and
the output calibration unit being configured to calibrate the second calculation result to obtain output calibration data, and output the output calibration data through an output end of the model architecture.

4. The model architecture according to claim 3, wherein
a first input end of the input calibration unit is an input end of the model architecture, and a second input end of the input calibration unit is connected to an output end of the first function calling unit;
an output end of the input calibration unit is connected to a first end of the logic unit, and a second end of the logic unit is connected to an input end of the output calibration unit; and
a first output end of the output calibration unit is the output end of the model architecture, and a second output end of the output calibration unit is connected to an input end of the second function calling unit.

5. The model architecture according to claim 3, wherein
the output calibration unit is further configured to transmit the output calibration data to the second function calling unit, to cause the second function calling unit to write the output calibration data into the external function.

6. The model architecture according to claim 3, wherein the input calibration unit is configured with a calibration switch and a calibration value that is in a one-to-one correspondence with the to-be-calibrated signal, and the calibrating, by the input calibration unit calibrates, a received to-be-calibrated signal when the model architecture is in an online debugging state comprises:
calibrating the to-be-calibrated signal based on the calibration switch and the calibration value, wherein the calibration switch comprises a turned-on state and a turned-off state, and the calibration value comprises the to-be-calibrated signal or a preset value corresponding to the to-be-calibrated signal.

7. The model architecture according to claim 6, wherein the calibrating, by the calibration unit, the to-be-calibrated signal based on the calibration switch and the calibration value comprises:
receiving a calibration instruction inputted by a user, the calibration instruction being used for controlling the turned-on state or the turned-off state of the calibration switch,
wherein when the calibration instruction is to turn on the calibration switch, the calibration value corresponding to the to-be-calibrated signal is outputted; or
when the calibration instruction is to turn off the calibration switch, the to-be-calibrated signal is outputted.

8. The model architecture according to any one of claims 1 to 7, further comprising a model auxiliary unit, the model auxiliary unit being configured to store model information; and
the model information comprising a model version number, a model item number, and a model scheduling period of the model architecture.

9. The model architecture according to claim 8, wherein the model auxiliary unit is configured to:
receive, when the software model architecture is in the online debugging state, a query instruction inputted by the user; and
output the model information based on the query instruction.

10. A battery management system controller, comprising a control chip and a software model architecture arranged on the control chip, the software model architecture being the software model architecture according to any one of claims 1 to 9.

11. A vehicle, comprising the battery management system controller according to claim 10.
